# EUROPEAN PATENT APPLICATION

(11) **EP 4 797 885 A1**
(43) Date of publication of application: **26.08.2026**
(21) Application number: 24880882.6
(22) Date of filing: 29.01.2024
(51) Int. Cl.: H05K 5/02

(54) **ELECTRIC CONTROL BOX AND ELECTRICAL DEVICE**

(30) Priority: 25.10.2023 CN 202311399690; 25.10.2023 CN 202322884066 U
(71) Applicant: GD Midea Air-Conditioning Equipment Co., Ltd., Foshan, Guangdong 528311 (CN)
(72) Inventor: YANG, Hongqiang, Foshan, Guangdong 528311 (CN); LI, Zhi, Foshan, Guangdong 528311 (CN); DENG, Jiquan, Foshan, Guangdong 528311 (CN)
(74) Representative: Ran, Handong
(86) International application number: PCT/CN2024/074450
(87) International publication number: WO 2025/086495

(57) **Abstract**

Disclosed in the present application are an electric control box and an electrical device. The electric control box comprises a box cover and a box body, which are connected to each other and define a mounting cavity, wherein one of the box cover and the box body is provided with a wire passage slot, through which a wire passes, and an elastic sealing member, at least part of the elastic sealing member being located in the wire passage slot; and the other one of the box cover and the box body is provided with a sealing protrusion, the sealing protrusion being configured to protrude towards the interior of the wire passage slot, and the sealing protrusion being adapted to press the wire towards the elastic sealing member.

## Description

### CROSS-REFERENCE TO RELATED APPLICATIONS

This application claims priorities to Chinese Patent Applications No. 202311399690.8, filed on October 25, 2023 and entitled "ELECTRIC CONTROL BOX AND ELECTRICAL DEVICE", and No. 202322884066.9, filed on October 25, 2023 and entitled "ELECTRIC CONTROL BOX AND ELECTRICAL DEVICE", the entire contents of which are incorporated herein by reference.

### FIELD

The present disclosure relates to the technical field of household air conditioners, and in particular, to an electric control box and an electrical device having the same.

### BACKGROUND

As governments worldwide place increasing emphasis on environmental protection, and with a quota for conventional refrigerants being limited, the use of environmentally friendly refrigerants is gradually on the rise. Such refrigerants have relatively flammable characteristics. In order to prevent ignition and combustion caused by contact between a leaked refrigerant and an electronic control component under a severe operating condition, a device using this type of refrigerant is required to ensure sealing of an electric control box. Sealing of a wire passing slot of the electric control box of the existing device using this type of refrigerant is generally achieved by filling the slot with sponge. During production, an employee on a production line needs to wrap the sponge around a wire body, which results in low efficiency and poor reliability of the manual operation, leaving room for improvement.

### SUMMARY

The present disclosure aims to at least solve one of the technical problems existing in the related art. Therefore, the present disclosure provides an electric control box that has good sealing performance and high reliability, and is capable of improving production efficiency.

The electric control box according to the embodiments of the present disclosure includes a box cover and a box body. The box cover and the box body are connected to each other and define a mounting cavity. One of the box cover and the box body has a wire passing slot and an elastic sealing member. The wire passing slot is configured to allow a wire body to pass through the wire passing slot, and the elastic sealing member is at least partially located in the wire passing slot; and the other one of the box cover and the box body is provided with a sealing protrusion configured to protrude towards an interior of the wire passing slot. The sealing protrusion is adapted to press the wire body towards the elastic sealing member.

In the electric control box according to the embodiments of the present disclosure, the one of the box cover and the box body has the wire passing slot and the elastic sealing member, and the other one of the box cover and the box body is provided with the sealing protrusion. In this way, when the wire body passes through the wire passing slot and penetrates the elastic sealing member, the sealing performance of the electric control box can be ensured, further improving the reliability of the electric control box during use and avoiding safety hazards caused by refrigerant leakage or other situations. Moreover, the wire body can be allowed to directly pass through the wire passing slot and penetrate the elastic sealing member, which improves the production efficiency, achieves a better use effect, and has a wider application range.

In the electric control box according to some embodiments of the present disclosure, the elastic sealing member includes a sealing portion and a mounting portion. The mounting portion is connected to the one of the box cover and the box body; and the sealing portion is located in the wire passing slot and has a wire passing notch facing the sealing protrusion.

In the electric control box according to some embodiments of the present disclosure, the sealing portion further has a first weakening slit in communication with the wire passing notch. The first weakening slit is open towards the sealing protrusion.

In the electric control box according to some embodiments of the present disclosure, a protruding direction of the sealing protrusion is the same as an extending direction of the first weakening slit.

In the electric control box according to some embodiments of the present disclosure, a plurality of sealing portions are provided and arranged at intervals in the wire passing slot in a wire passing direction.

In the electric control box according to some embodiments of the present disclosure, a plurality of mounting portions and a plurality of sealing portions are provided and alternately distributed, and a plurality of wire passing slots are provided and arranged in a one-to-one correspondence with the plurality of sealing portions.

In the electric control box according to some embodiments of the present disclosure, the mounting portion is provided with a fool-proofing positioning portion; and the one of the box cover and the box body is provided with a fool-proofing engagement portion. The fool-proofing positioning portion is configured to be engaged with the fool-proofing engagement portion by insertion for positioning.

In the electric control box according to some embodiments of the present disclosure, at least two fool-proofing positioning portions are provided.

In the electric control box according to some embodiments of the present disclosure, the elastic sealing member further includes a shielding portion located in the wire passing slot and arranged directly facing the sealing portion in a wire passing direction. The shielding portion is located at a side of the sealing portion away from the mounting cavity and has a second weakening slit.

In the electric control box according to some embodiments of the present disclosure, the second weakening slit is at least partially distributed directly facing the wire passing notch in the wire passing direction.

In the electric control box according to some embodiments of the present disclosure, an extending length of the second weakening slit is greater than a protruding length of the sealing protrusion.

In the electric control box according to some embodiments of the present disclosure, a protruding direction of the sealing protrusion is the same as an extending direction of the second weakening slit.

In the electric control box according to some embodiments of the present disclosure, a plurality of wire passing slots and a plurality of sealing protrusions are provided. The plurality of sealing protrusions are arranged in a one-to-one correspondence with the plurality of wire passing slots.

In the electric control box according to some embodiments of the present disclosure, the box body has the wire passing slot opening towards the box cover, and the sealing protrusion is disposed at the box cover.

In the electric control box according to some embodiments of the present disclosure, the box body has a mounting recess. The wire passing slot is in communication with and extends through the mounting recess, and the elastic sealing member is mounted in the mounting recess.

In the electric control box according to some embodiments of the present disclosure, the box cover further includes a shielding plate distributed directly facing the sealing protrusion in a wire passing direction and located at a side of the sealing protrusion away from the mounting cavity.

In the electric control box according to some embodiments of the present disclosure, the box body has a mounting opening. The box cover is detachably mounted at the mounting opening to define the mounting cavity together with the box body.

The present disclosure further provides an electrical device.

The electrical device according to the embodiments of the present disclosure includes the electric control box according to any one of the above embodiments.

The electrical device and the above electric control box have the same advantages over the prior art, and details thereof are omitted herein.

Additional aspects and advantages of the present disclosure will be provided in part in the following description, or will become apparent in part from the following description, or can be learned from practicing of the present disclosure.

### BRIEF DESCRIPTION OF THE DRAWINGS

The above and/or additional aspects and advantages of the present disclosure will become more apparent and more understandable from the following description of embodiments taken in conjunction with the accompanying drawings, in which:
FIG. 1 is a first schematic structural view of an electric control box according to an embodiment of the present disclosure;
FIG. 2 is a second schematic structural view of an electric control box according to an embodiment of the present disclosure;
FIG. 3 is a first cross-sectional view of an electric control box according to an embodiment of the present disclosure;
FIG. 4 is a second cross-sectional view of an electric control box according to an embodiment of the present disclosure;
FIG. 5 is a partial cross-sectional view of an electric control box according to an embodiment of the present disclosure;
FIG. 6 is a schematic structural view of a box body according to an embodiment of the present disclosure;
FIG. 7 is a partial schematic structural view of a box body according to an embodiment of the present disclosure;
FIG. 8 is a schematic structural view of a box cover according to an embodiment of the present disclosure; and
FIG. 9 is a cross-sectional view of a box cover according to an embodiment of the present disclosure.

### Reference numerals:

electric control box 100,
box cover 1, sealing protrusion 11, shielding plate 12, pre-fixing portion 13,
box body 2, mounting recess 21, wire passing slot 22, elastic sealing member 23, sealing portion 231, wire passing notch 2311, first weakening slit 2312, mounting portion 232, fool-proofing positioning portion 2321, shielding portion 233, second weakening slit 2331, mounting opening 24, fool-proofing engagement portion 25, pre-engagement portion 26.

### DETAILED DESCRIPTION

In the description of the present disclosure, it should be understood that the orientation or the position indicated by terms such as "center," "longitudinal," "lateral," "length," "width," "thickness," "over," "below," "front," "rear," "left," "right," "vertical," "horizontal," "top," "bottom," "inner," "outer," "clockwise," "anti-clockwise," "axial," "radial," and "circumferential" should be construed to refer to the orientation or the position as shown in the drawings, and is only for the convenience of describing the present disclosure and simplifying the description, rather than indicating or implying that the pointed device or element must have a specific orientation, or be constructed and operated in a specific orientation, and therefore cannot be understood as a limitation of the present disclosure. In addition, features associated with "first" and "second" may include at least one or more such features, either explicitly or implicitly. In the description of the present disclosure, unless otherwise indicated, "plurality of" means two or more.

In the present disclosure, it should be noted that, unless otherwise clearly specified and limited, terms such as "mount", "connect", "couple", and the like should be understood in a broad sense. For example, it may be a fixed connection or a detachable connection or connection as one piece; a mechanical connection or an electrical connection; a direct connection or an indirect connection through an intermediate; or internal communication of two components. For those of ordinary skill in the art, the specific meaning of the above terms in the present disclosure should be understood according to specific circumstances.

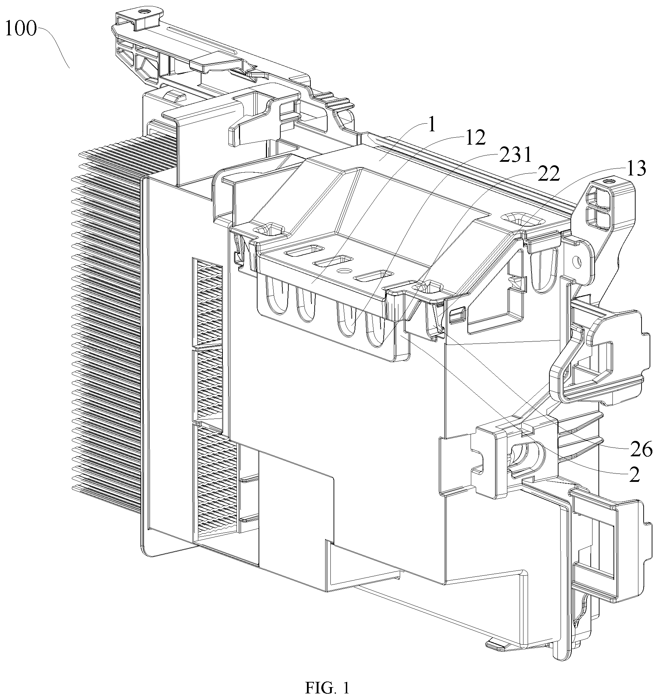

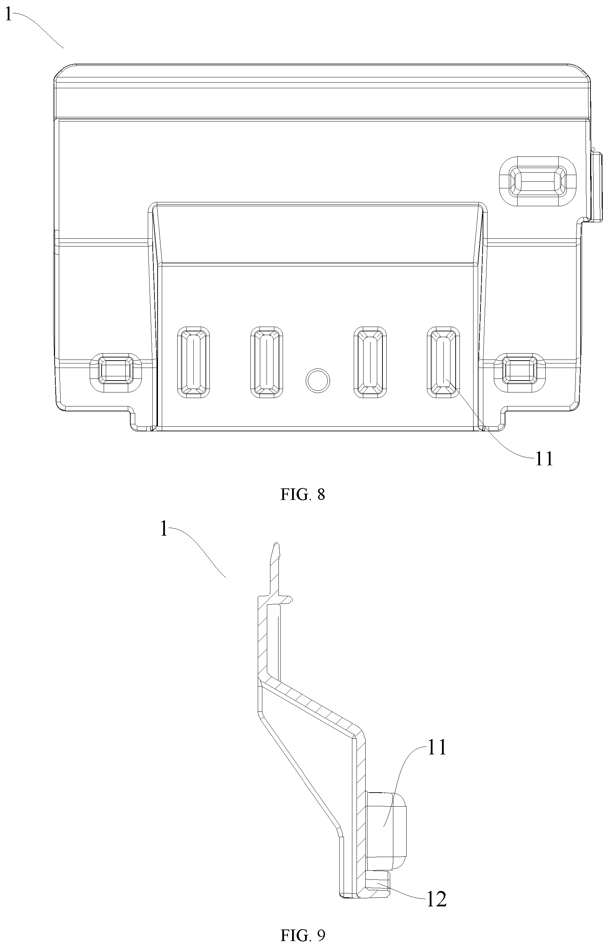

An electric control box 100 according to the embodiments of the present disclosure will be described below with reference to FIG. 1 to FIG. 9. The electric control box 100 has good sealing performance and high reliability, and is capable of improving production efficiency.

As shown in FIG. 1 to FIG. 9, the electric control box 100 according to the embodiments of the present disclosure includes a box cover 1 and a box body 2.

The box cover 1 and the box body 2 are connected to each other and define a mounting cavity. One of the box cover 1 and the box body 2 has a wire passing slot 22 and an elastic sealing member 23. The wire passing slot 22 is configured to allow a wire body to pass through the wire passing slot 22. The elastic sealing member 23 is at least partially located in the wire passing slot 22. The other one of the box cover 1 and the box body 2 is provided with a sealing protrusion 11 configured to protrude towards an interior of the wire passing slot 22. The sealing protrusion 11 is adapted to press the wire body towards the elastic sealing member 23.

The electric control box 100 may be applied to an electrical device, such as an air conditioner, and may serve as an electronic controller box in an outdoor unit of the air conditioner. Its main function is to control operation of an air conditioner component, such as a compressor, a fan, and an electric heating tape. The electric control box 100 generally includes a microprocessor, a power supply, an input/output interface, a protection circuit, and the like, to control operation and temperature adjustment of the air conditioner.

That is, the electric control box 100 is provided with the box cover 1 and the box body 2 that are engaged and connected to each other. Moreover, after the box cover 1 is connected to the box body 2, the mounting cavity may be defined by the box cover 1 and the box body 2, and the mounting cavity is capable of accommodating electronic components to realize various functions of the electrical device. The one of the box cover 1 and the box body 2 has the wire passing slot 22 and the elastic sealing member 23, and the wire passing slot 22 is configured to allow the wire body to pass through the wire passing slot 22. The other one of the box cover 1 and the box body 2 is provided with the sealing protrusion 11. That is, the wire passing slot 22 and the elastic sealing member 23 may be disposed at the box cover 1, and the sealing protrusion 11 is disposed at the box body 2. Alternatively, the wire passing slot 22 and the elastic sealing member 23 may be disposed at the box body 2, and the sealing protrusion 11 is disposed at the box cover 1. For example, in the description of the embodiments of the present disclosure, the arrangement, in which the wire passing slot 22 and the elastic sealing member 23 are disposed at the box body 2 and the sealing protrusion 11 is disposed at the box cover 1, is taken as an example for illustration.

The box body 2 has the wire passing slot 22 configured to allow the wire body to pass through the wire passing slot 22, enabling the wire body to extend from an outer side to an inner side of the electric control box 100. The elastic sealing member 23 may be made of rubber or other elastic materials, and is partially located in the wire passing slot 22. The wire body may pass through the wire passing slot 22 and penetrate the elastic sealing member 23 located in the wire passing slot 22, to penetrate the electric control box 100. Moreover, the box cover 1 is provided with the sealing protrusion 11 matched with the wire passing slot 22. When the box cover 1 is connected to the box body 2, the sealing protrusion 11 protrudes towards the interior of the wire passing slot 22. In this way, after the box cover 1 is connected to the box body 2, the sealing protrusion 11 can press the wire body towards the elastic sealing member 23, which can improve the sealing performance of the electric control box 100 when the wire body penetrates the electric control box 100, ensure the reliability of the electric control box 100 during use, and avoid safety hazards caused by refrigerant leakage or other situations. Meanwhile, a protruding part of the sealing protrusion 11 has a rounded corner, which can prevent damage to the elastic sealing member 23 and the wire body penetrating the elastic sealing member 23.

In the electric control box 100 according to the embodiments of the present disclosure, the one of the box cover 1 and the box body 2 has the wire passing slot 22 and the elastic sealing member 23, and the other one of the box cover 1 and the box body 2 is provided with the sealing protrusion 11. In this way, when the wire body passes through the wire passing slot 22 and penetrates the elastic sealing member 23, the sealing performance of the electric control box 100 can be ensured, further improving the reliability of the electric control box 100 during use, and avoiding the safety hazards caused by refrigerant leakage or other situations. Moreover, the wire body can be allowed to directly pass through the wire passing slot 22 and penetrate the elastic sealing member 23, which improves the production efficiency, achieves a better use effect, and has a wider application range.

In some embodiments, the elastic sealing member 23 includes a sealing portion 231 and a mounting portion 232. The mounting portion 232 is connected to the one of the box cover 1 and the box body 2. The sealing portion 231 is located in the wire passing slot 22 and has a wire passing notch 2311 facing the sealing protrusion 11.

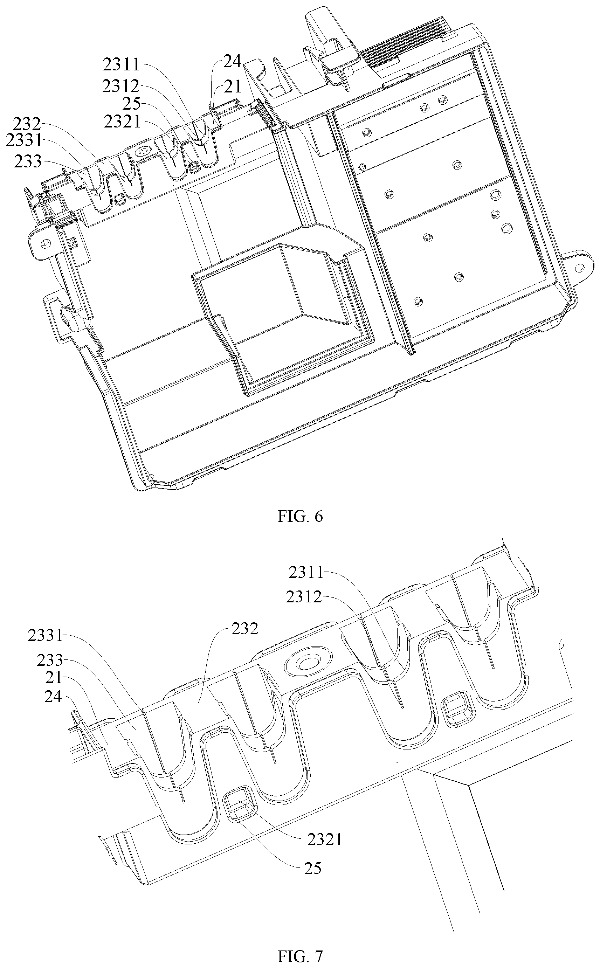

As shown in FIG. 6 and FIG. 7, the elastic sealing member 23 is provided with the sealing portion 231 and the mounting portion 232. The mounting portion 232 is connected to the one of the box cover 1 and the box body 2. That is, when the elastic sealing member 23 is disposed at the box cover 1, the mounting portion 232 is connected to the box cover 1. When the elastic sealing member 23 is disposed at the box body 2, the mounting portion 232 is connected to the box body 2. In this embodiment, the elastic sealing member 23 is disposed at the box body 2, i.e., the mounting portion 232 is connected to the box body 2, and the sealing portion 231 is located in the wire passing slot 22. Moreover, the sealing portion 231 has the wire passing notch 2311 facing the sealing protrusion 11. The wire passing notch 2311 may be formed in a circular arc shape, and a side of the sealing protrusion 11 facing the wire passing slot 22 is formed as a circular arc surface that is engaged with the wire passing notch 2311. When the box cover 1 is connected to the box body 2, the sealing protrusion 11 may be placed into the wire passing notch 2311 and then pressed against the sealing portion 231, allowing the sealing protrusion 11 to be in an interference fit with the sealing portion 231. In this way, a sealing effect of the elastic sealing member 23 can be ensured when the sealing protrusion 11 presses against the sealing portion 231.

In some embodiments, the sealing portion 231 further has a first weakening slit 2312 in communication with the wire passing notch 2311. The first weakening slit 2312 is open towards the sealing protrusion 11.

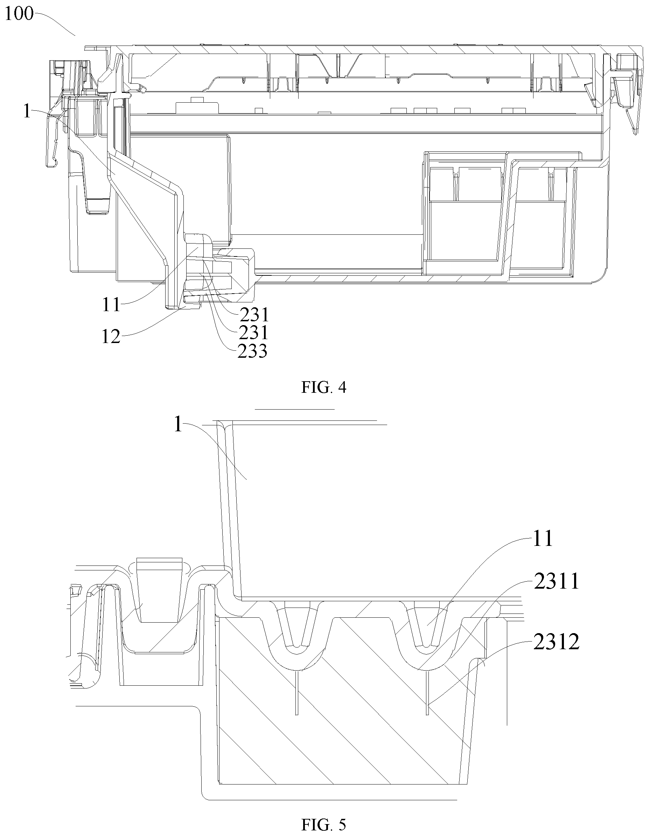

As shown in FIG. 5 to FIG. 7, the sealing portion 231 has the first weakening slit 2312 that penetrates the sealing portion 231 in a wire passing direction, enabling the wire body to pass through the first weakening slit 2312 to extend into an interior of the electric control box 100. Moreover, the first weakening slit 2312 is open towards the sealing protrusion 11, enabling the wire body to be placed into the first weakening slit 2312 from the opening of the first weakening slit 2312. When the box cover 1 is connected to the box body 2, the sealing protrusion 11 may be placed in the wire passing notch 2311 and further pressed against the sealing portion 231. The first weakening slit 2312 is open towards the sealing protrusion 11, such that when the sealing protrusion 11 is pressed into the wire passing notch 2311, the opening of the first weakening slit 2312 facing the sealing protrusion 11 can be closed, improving the sealing performance of the electric control box 100.

In some embodiments, a protruding direction of the sealing protrusion 11 is the same as an extending direction of the first weakening slit 2312.

The sealing protrusion 11 is configured to protrude towards the interior of the wire passing slot 22, and the protruding direction of the sealing protrusion 11 is the same as the extending direction of the first weakening slit 2312. Moreover, when the protruding direction of the sealing protrusion 11 is upward, an opening direction of the first weakening slit 2312 is downward. When the protruding direction of the sealing protrusion 11 is downward, the opening direction of the first weakening slit 2312 is upward. That is, each of the protruding direction of the sealing protrusion 11 and the extending direction of the first weakening slit 2312 is an up-down direction. When the box cover 1 is connected to the box body 2, the sealing protrusion 11 presses against the sealing portion 231 to close the opening of the first weakening slit 2312 facing the sealing protrusion 11. Moreover, when the sealing protrusion 11 presses against the wire passing notch 2311, since the sealing protrusion 11 is in an interference fit with the sealing portion 231, the sealing protrusion 11 can further press against the first weakening slit 2312, and its protruding direction is the same as the extending direction of the first weakening slit 2312. In this way, when the sealing protrusion 11 presses against the first weakening slit 2312, the sealing protrusion 11 can press against the first weakening slit 2312 in the extending direction of the first weakening slit 2312, achieving a better sealing effect of the sealing protrusion 11 on the first weakening slit 2312, and improving the sealing performance of the electric control box 100.

In some embodiments, a plurality of sealing portions 231 are provided and arranged at intervals in the wire passing slot 22 in a wire passing direction.

As shown in FIG. 6 and FIG. 7, the box body 2 is provided with the elastic sealing member 23 having the mounting portion 232 and the sealing portion 231. The wire body may extend into the interior of the electric control box 100 through the first weakening slit 2312 disposed in the sealing portion 231. The plurality of sealing portions 231 are provided and arranged at intervals in the wire passing slot 22 in the wire passing direction. The plurality of sealing portions 231 has a plurality of first weakening slits 2312. In this way, the wire body can be allowed to extend into the electric control box 100 through the first weakening slits 2312, making wire body arrangement more regular. Moreover, fewer wire bodies pass through each first weakening slit 2312, which can improve sealing performance of the sealing portions 231, avoid sealing failure of the sealing portions 231 caused by excessive wire bodies in one sealing portion 231, and improve reliability of the sealing portions 231.

In some embodiments, a plurality of mounting portions 232 and a plurality of sealing portions 231 are provided and alternately distributed, and a plurality of wire passing slots 22 are provided and arranged in a one-to-one correspondence with the plurality of sealing portions 231.

As shown in FIG. 6 and FIG. 7, the box body 2 is provided with the elastic sealing member 23 having the mounting portion 232 and the sealing portion 231. The mounting portion 232 is configured to interact with the box body 2 to fix the elastic sealing member 23 relative to the box body 2. The sealing portion 231 is configured to allow the wire body to penetrate the sealing portion 231, and allow the electric control box 100 to be in a sealing state. The plurality of mounting portions 232 and the plurality of sealing portions 231 are provided. The plurality of mounting portions 232 are provided, enabling a firmer connection between the elastic sealing member 23 and the box body 2. The plurality of sealing portions 231 and the plurality of wire passing slots 22 are provided. The plurality of wire passing slots 22 are arranged in a one-to-one correspondence with the plurality of sealing portions 231, enabling the wire body arrangement more uniform. Moreover, fewer wire bodies penetrate each sealing portion 231, which can improve the sealing performance of the sealing portions 231. Meanwhile, the plurality of sealing portions 231 and the plurality of mounting portions 232 are alternately distributed, i.e., the mounting portions 232 are disposed between a plurality of wire bodies, making mounting reliability of the wire bodies higher.

In some embodiments, the mounting portion 232 is provided with a fool-proofing positioning portion 2321; and the one of the box cover 1 and the box body 2 is provided with a fool-proofing engagement portion 25. The fool-proofing positioning portion 2321 is configured to be engaged with the fool-proofing engagement portion 25 by insertion for positioning.

As shown in FIG. 6 and FIG. 7, the mounting portion 232 is provided with the fool-proofing positioning portion 2321. Fool-proofing refers to a preventive and corrective behavioral constraint measure, which adopts a limiting method for preventing an error and enables an operator to complete a correct operation directly and accurately without requiring concentration, experience, and professional knowledge. That is, the mounting portion 232 is provided with the fool-proofing positioning portion 2321, enabling mounting of the mounting portion 232 to be simpler and saving mounting time.

In some embodiments, the fool-proofing positioning portion 2321 may be configured as a positioning protrusion, and the fool-proofing engagement portion 25 may be configured as a fool-proofing positioning groove. The positioning protrusion may be engaged into the fool-proofing positioning groove. Alternatively, one of the fool-proofing positioning portion 2321 and the fool-proofing engagement portion 25 may be configured as a positioning post, and the other one of the fool-proofing positioning portion 2321 and the fool-proofing engagement portion 25 may be configured as a positioning hole, both of which can be engaged with each other by insertion for positioning.

In some embodiments, the one of the box cover 1 and the box body 2 is provided with the fool-proofing engagement portion 25. That is, when the wire passing slot 22 and the elastic sealing member 23 are disposed at the box cover 1, the fool-proofing engagement portion 25 is also disposed at the box cover 1. When the wire passing slot 22 and the elastic sealing member 23 are disposed at the box body 2, the fool-proofing engagement portion 25 is also disposed at the box body 2. In this embodiment, the fool-proofing engagement portion 25 is disposed at the box body 2. The fool-proofing positioning portion 2321 may be engaged with the fool-proofing engagement portion 25 by insertion for positioning. In this way, the mounting portion 232 can be accurately mounted in the box body 2, saving mounting time of the mounting portion 232 and the box body 2 and improving mounting accuracy.

In some embodiments, at least two fool-proofing positioning portions 2321 are provided. That is, two, three, four, or more fool-proofing positioning portions 2321 may be provided. As shown in FIG. 6 and FIG. 7, in this embodiment, two fool-proofing positioning portions 2321 are provided and spaced apart from each other on the mounting portion 232 in the wire passing direction. After the mounting portion 232 is mounted at the box body 2, the fool-proofing positioning portion 2321 may be engaged with the fool-proofing engagement portion 25 by insertion for positioning. When the mounting portion 232 is subjected to an acting force, the fool-proofing positioning portion 2321 interacts with the fool-proofing engagement portion 25. The arrangement of two fool-proofing positioning portions 2321 enables the acting force to be evenly distributed to each fool-proofing positioning portion 2321, which can avoid fracture of one of the fool-proofing positioning portion 2321 caused by excessive stress, prolong a service life of the fool-proofing positioning portion 2321, and improve reliability of the fool-proofing positioning portion 2321.

In some embodiments, the elastic sealing member 23 further includes a shielding portion 233 located in the wire passing slot 22 and arranged directly facing the sealing portion 231 in a wire passing direction. The shielding portion 233 is located at a side of the sealing portion 231 away from the mounting cavity and has a second weakening slit 2331.

As shown in FIG. 4, FIG. 6, and FIG. 7, the elastic sealing member 23 further includes the shielding portion 233 disposed in the wire passing slot 22 and arranged directly facing the sealing portion 231 in the wire passing direction. The shielding portion 233 is located at the side of the sealing portion 231 away from the mounting cavity, i.e., the shielding portion 233 is disposed at a side of the electric control box 100 adjacent to an external environment. The wire body penetrates the shielding portion 233 before passing through the wire passing slot 22. The sealing portion 231 has the wire passing notch 2311, which allows the shielding portion 233 to have a greater length than the sealing portion 231 in a direction towards the sealing protrusion 11. In this way, when the box cover 1 is connected to the box body 2, the shielding portion 233 can achieve a shielding effect on the sealing portion 231 to improve the sealing performance. Moreover, the shielding portion 233 has the second weakening slit 2331, and the wire body may penetrate the shielding portion 233 through the second weakening slit 2331, enabling the wire body to extend into the interior of the electric control box 100 while ensuring the sealing performance, and ensuring the reliability of the electric control box 100.

In some embodiments, the second weakening slit 2331 is at least partially distributed directly facing the wire passing notch 2311 in the wire passing direction.

As shown in FIG. 6 and FIG. 7, the second weakening slit 2331 is formed at the shielding portion 233, and an end of the second weakening slit 2331 towards the sealing protrusion 11 is open. The second weakening slit 2331 is at least partially distributed directly facing the wire passing notch 2311 in the wire passing direction. That is, when the box cover 1 is connected to the box body 2, the sealing protrusion 11 is placed into the wire passing notch 2311 and pressed against the sealing portion 231. At this time, the second weakening slit 2331 is at least partially distributed directly facing the pressing position. In this way, when the wire body passes through the second weakening slit 2331 and then penetrates the sealing portion 231, the wire body can be pressed by the sealing protrusion 11, achieving the sealing effect on the first weakening slit 2312 and improving the reliability of the electric control box 100 during use.

In some embodiments, an extending length of the second weakening slit 2331 is greater than a protruding length of the sealing protrusion 11.

In an exemplary embodiment of the present disclosure, as shown in FIG. 6 and FIG. 7, an opening direction of the second weakening slit 2331 is opposite to the protruding direction of the sealing protrusion 11, and the extending length of the second weakening slit 2331 is greater than the protruding length of the sealing protrusion 11. When the box cover 1 is connected to the box body 2, the sealing protrusion 11 presses against the sealing portion 231 to seal the box body 2. The shielding portion 233 is disposed at the side of the sealing portion 231 away from the mounting cavity to achieve the shielding effect on the sealing portion 231. The extending length of the second weakening slit 2331 is set to be greater than the protruding length of the sealing protrusion 11. In this way, when the sealing protrusion 11 presses against the sealing portion 231, the wire body can easily pass through the second weakening slit 2331 and be placed in the first weakening slit 2312 without obstruction, facilitating routing of the wire body, and saving operation time.

In some embodiments, a protruding direction of the sealing protrusion 11 is the same as an extending direction of the second weakening slit 2331.

In an exemplary embodiment of the present disclosure, the sealing protrusion 11 is configured to protrude towards the interior of the wire passing slot 22, and the protruding direction of the sealing protrusion 11 is the same as the extending direction of the second weakening slit 2331. Moreover, when the protruding direction of the sealing protrusion 11 is upward, the opening direction of the second weakening slit 2331 is downward. When the protruding direction of the sealing protrusion 11 is downward, the opening direction of the second weakening slit 2331 is upward. The second weakening slit 2331 is formed at the shielding portion 233. The arrangement of the second weakening slit 2331 at the shielding portion 233 can shield the sealing portion 231 while allowing the wire body to pass through the second weakening slit 2331, improving the sealing performance. When the box cover 1 is connected to the box body 2, the sealing protrusion 11 presses against the sealing portion 231. The protruding direction of the sealing protrusion 11 is the same as the extending direction of the second weakening slit 2331 and the extending direction of the first weakening slit 2312. That is, the first weakening slit 2312 and the second weakening slit 2331 have the same extending direction. When the sealing protrusion 11 presses against the first weakening slit 2312, the sealing protrusion 11 can press against the first weakening slit 2312 in the extending direction of the first weakening slit 2312. Moreover, the wire body may pass through the second weakening slit 2331 into the first weakening slit 2312. In this way, the sealing portion 231 can be protected while ensuring a sealing effect of the first weakening slit 2312, prolonging a service life of the sealing portion 231.

In some embodiments, a plurality of wire passing slots 22 and a plurality of sealing protrusions 11 are provided. The plurality of sealing protrusions 11 are arranged in a one-to-one correspondence with the plurality of wire passing slots 22.

As shown in FIG. 1 to FIG. 9, the box body 2 has the wire passing slot 22, and the box cover 1 is provided with the sealing protrusion 11. The wire passing slot 22 may be configured to allow the wire body to pass through the wire passing slot 22. When the box cover 1 is connected to the box body 2, the sealing protrusion 11 is placed into the wire passing slot 22 to press against the sealing portion 231 mounted in the wire passing slot 22, realizing sealing of the electric control box 100 while allowing the wire body to penetrate the electric control box 100. The plurality of wire passing slots 22 and the plurality of sealing protrusions 11 may be provided. The plurality of sealing protrusions 11 are arranged in a one-to-one correspondence with the plurality of wire passing slots 22. That is, after the wire body passes through the wire passing slot 22, the corresponding sealing protrusion 11 presses against the sealing portion 231 in the wire passing slot 22, to seal the electric control box 100, improving the sealing performance. Moreover, the plurality of wire passing slots 22 are provided, enabling the wire body arrangement more uniform. Moreover, fewer wire bodies penetrate each sealing portion 231, which can further improve the sealing effect and enhance the reliability of the electric control box 100.

In some embodiments, the box body 2 has the wire passing slot 22 opening towards the box cover 1, and the sealing protrusion 11 is disposed at the box cover 1.

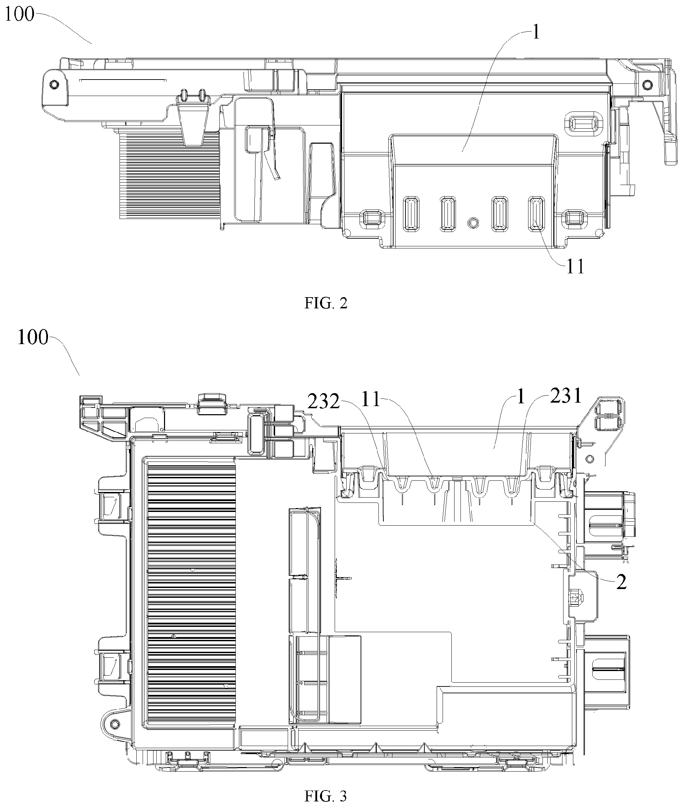

As shown in FIG. 3 to FIG. 5, the box body 2 has the wire passing slot 22 configured to allow the wire body to pass through the wire passing slot 22, enabling the wire body to extend from the outer side to the inner side of the electric control box 100. The elastic sealing member 23 may be made of rubber or other elastic materials, and is partially located in the wire passing slot 22. The wire body may pass through the wire passing slot 22 and penetrate the elastic sealing member 23 located in the wire passing slot 22, penetrating the electric control box 100. The wire passing slot 22 is open toward the box cover 1, and the box cover 1 is provided with the sealing protrusion 11 matched with the wire passing slot 22. When the box cover 1 is connected to the box body 2, the sealing protrusion 11 protrudes towards the interior of the wire passing slot 22. In this way, after the box cover 1 is connected to the box body 2, the sealing protrusion 11 can be placed into the wire passing slot 22 through the opening of the wire passing slot 22, compressing the elastic sealing member 23 in the wire passing slot, to improve the sealing performance of the electric control box 100 when the wire body penetrates the electric control box 100. Therefore, the reliability of the electric control box 100 during use can be ensured, and the safety hazards caused by refrigerant leakage or other situations can be avoided.

In some embodiments, the box body 2 has a mounting recess 21. The wire passing slot 22 is in communication with and extends through the mounting recess 21, and the elastic sealing member 23 is mounted in the mounting recess 21.

As shown in FIG. 6 and FIG. 7, the box body 2 has the mounting recess 21. An end of the mounting recess 21 towards the box cover 1 is open. The elastic sealing member 23 may be placed into the mounting recess 21 through the opening of the mounting recess 21. The wire passing slot 22 is in communication with and extends through the mounting recess 21. The sealing portion 231 of the elastic sealing member 23 is disposed corresponding to the wire passing slot 22. The wire body may pass through the wire passing slot 22 at a side of the box body 2, penetrate the sealing portion 231, and then extend out from the wire passing slot 22 at another side of the box body 2. In this way, the sealing performance of the electric control box 100 can be ensured while allowing the wire body to penetrate the electric control box 100, improving use safety of the electric control box 100.

In some embodiments, the box cover 1 further includes a shielding plate 12 distributed directly facing the sealing protrusion 11 in a wire passing direction and located at a side of the sealing protrusion 11 away from the mounting cavity.

As shown in FIG. 1, FIG. 4, and FIG. 9, the box cover 1 is further provided with the shielding plate 12 of a plate-like structure. The shielding plate 12 has an end connected to a main body of the box cover 1 and another end serving as a free end. The shielding plate 12 is distributed directly facing the sealing protrusion 11 in the wire passing direction, and is located at the side of the sealing protrusion 11 away from the mounting cavity. When the box cover 1 is connected to the box body 2, the sealing protrusion 11 presses against the sealing portion 231, and the wire body penetrates the sealing portion 231. The shielding plate 12 is distributed directly facing the sealing protrusion 11 in the wire passing direction, and is located at the side of the sealing protrusion 11 away from the mounting cavity. That is, the shielding plate 12 may shield a contact part between the sealing protrusion 11 and the sealing portion 231. The elastic sealing member 23 is made of rubber or other materials and has a relatively low strength. The shielding plate 12 can shield a part of the elastic sealing member 23 abutting with the sealing protrusion 11, preventing a poor sealing effect of the elastic sealing member 23 caused by external collision or the like, and improving the sealing performance of the electric control box 100.

In some embodiments, the box body 2 has a mounting opening 24. The box cover 1 is detachably mounted at the mounting opening 24 to define the mounting cavity together with the box body 2.

As shown in FIG. 6 and FIG. 7, the box body 2 has the mounting opening 24. The box cover 1 is detachably mounted at the mounting opening 24 to define the mounting cavity together with the box body 2. The mounting cavity is used for accommodating the electronic components. Moreover, the wire body may penetrate the sealing portion 231 to be connected to the electronic components, to realize various functions of the electrical device. The detachable arrangement of the box cover 1 with respect to the mounting opening 24 facilitates later maintenance and saves subsequent maintenance time.

In some embodiments, the one of the box cover 1 and the box body 2 is provided with a pre-fixing portion 13, and the other one of the box cover 1 and the box body 2 is provided with a pre-engagement portion 26. That is, the pre-fixing portion 13 may be disposed at either the box cover 1 or the box body 2, and the pre-engagement portion 26 may be disposed correspondingly at the other one of the box cover 1 and the box body 2. When the pre-fixing portion 13 is disposed at the box cover 1, the pre-engagement portion 26 is disposed at the box body 2. Similarly, when the pre-engagement portion 26 is disposed at the box body 2, the pre-fixing portion 13 is disposed at the box cover 1. In this embodiment, as shown in FIG. 1, the pre-fixing portion 13 is disposed at the box body 2, and the pre-engagement portion 26 is disposed at the box cover 1. The pre-fixing portion 13 may be configured as a snap, and the pre-engagement portion 26 may be configured as an engagement groove. The box cover 1 and the box body 2 may be connected and fixed by engaging the snap into the engagement groove, enabling the box cover 1 to be detachably connected to the box body 2, making more convenient use.

The present disclosure further provides an electrical device.

The electrical device according to the embodiments of the present disclosure includes the electric control box 100 according to any one of the above embodiments.

The electrical device according to the embodiments of the present disclosure includes the electric control box 100. In the electric control box 100, the one of the box cover 1 and the box body 2 has the wire passing slot 22 and the elastic sealing member 23, and the other one of the box cover 1 and the box body 2 is provided with the sealing protrusion 11, which can ensure the sealing performance of the electric control box 100 when the wire body passes through the wire passing slot 22 and penetrates the elastic sealing member 23. In this way, the reliability of the electric control box 100 during use is improved, and the safety hazards caused by refrigerant leakage or other situations are avoided. Moreover, the wire body can be allowed to directly pass through the wire passing slot 22 and penetrate the elastic sealing member 23, which improves the production efficiency, achieves the better use effect, and has the wider application range.

The electrical device may be the outdoor unit of the air conditioner or other types of household electrical appliances. That is, the electric control box 100 may be applied to various types of electrical devices.

Throughout this specification, description with reference to "an embodiment", "some embodiments", "an illustrative embodiment", "an example", "a specific example", "some examples", or the like means that a particular feature, structure, material, or characteristic described in connection with the embodiment or example is included in at least one embodiment or example of the present disclosure. The appearances of the above phrases in various places throughout this specification are not necessarily referring to the same embodiment or example of the present disclosure. Further, the particular features, structures, materials, or characteristics described here may be combined in any suitable manner in one or more embodiments or examples.

Although embodiments of the present disclosure have been illustrated and described, it is conceivable for those skilled in the art that various changes, modifications, replacements, and variations can be made to these embodiments without departing from the principles and spirit of the present disclosure. The scope of the present disclosure shall be defined by the claims as appended and their equivalents.

## Claims

1. An electric control box, comprising:
a box cover; and
a box body, wherein the box cover and the box body are connected to each other and define a mounting cavity, wherein:
one of the box cover and the box body has a wire passing slot and an elastic sealing member, the wire passing slot being configured to allow a wire body to pass through the wire passing slot, and the elastic sealing member being at least partially located in the wire passing slot; and
the other one of the box cover and the box body is provided with a sealing protrusion configured to protrude towards an interior of the wire passing slot, the sealing protrusion being adapted to press the wire body towards the elastic sealing member.

2. The electric control box according to claim 1, wherein the elastic sealing member comprises a sealing portion and a mounting portion, wherein:
the mounting portion is connected to the one of the box cover and the box body; and
the sealing portion is located in the wire passing slot and has a wire passing notch facing the sealing protrusion.

3. The electric control box according to claim 2, wherein the sealing portion further has a first weakening slit in communication with the wire passing notch, the first weakening slit being open towards the sealing protrusion.

4. The electric control box according to claim 3, wherein a protruding direction of the sealing protrusion is the same as an extending direction of the first weakening slit.

5. The electric control box according to any one of claims 2 to 4, wherein the elastic sealing member comprises a plurality of sealing portions arranged at intervals in the wire passing slot in a wire passing direction.

6. The electric control box according to any one of claims 2 to 5, wherein:
the elastic sealing member comprises a plurality of mounting portions and a plurality of sealing portions that are alternately distributed; and
said one of the box cover and the box body has a plurality of wire passing slots that are arranged in a one-to-one correspondence with the plurality of sealing portions.

7. The electric control box according to any one of claims 2 to 6, wherein:
the mounting portion is provided with a fool-proofing positioning portion; and
the one of the box cover and the box body is provided with a fool-proofing engagement portion, wherein the fool-proofing positioning portion is configured to be engaged with the fool-proofing engagement portion by insertion for positioning.

8. The electric control box according to claim 7, wherein the mounting portion is provided with at least two fool-proofing positioning portions.

9. The electric control box according to any one of claims 2 to 8, wherein the elastic sealing member further comprises a shielding portion located in the wire passing slot and arranged directly facing the sealing portion in a wire passing direction, wherein the shielding portion is located at a side of the sealing portion away from the mounting cavity and has a second weakening slit.

10. The electric control box according to claim 9, wherein the second weakening slit is at least partially distributed directly facing the wire passing notch in the wire passing direction.

11. The electric control box according to claim 9 or 10, wherein an extending length of the second weakening slit is greater than a protruding length of the sealing protrusion.

12. The electric control box according to any one of claims 9 to 11, wherein a protruding direction of the sealing protrusion is the same as an extending direction of the second weakening slit.

13. The electric control box according to any one of claims 1 to 12, wherein said one of the box cover and the box body has a plurality of wire passing slots, and said the other one of the box cover and the box body is provided with a plurality of sealing protrusions, the plurality of sealing protrusions being arranged in a one-to-one correspondence with the plurality of wire passing slots.

14. The electric control box according to any one of claims 1 to 13, wherein:
the box body has the wire passing slot opening towards the box cover; and
the sealing protrusion is disposed at the box cover.

15. The electric control box according to claim 14, wherein the box body has a mounting recess, the wire passing slot being in communication with and extending through the mounting recess, and the elastic sealing member being mounted in the mounting recess.

16. The electric control box according to claim 14 or 15, wherein the box cover further comprises a shielding plate distributed directly facing the sealing protrusion in a wire passing direction and located at a side of the sealing protrusion away from the mounting cavity.

17. The electric control box according to any one of claims 1 to 16, wherein the box body has a mounting opening, the box cover being detachably mounted at the mounting opening to define the mounting cavity together with the box body.

18. An electrical device, comprising the electric control box according to any one of claims 1 to 17.
